# EUROPEAN PATENT APPLICATION

(11) **EP 4 458 902 A1**
(43) Date of publication of application: **06.11.2024**
(21) Application number: 22915034.7
(22) Date of filing: 29.12.2022
(51) Int. Cl.: C08L 63/10, C08L 61/34, C08L 79/08, C08K 3/36, C08K 9/04, C08K 7/18, B32B 15/20, B32B 15/04, B32B 17/04, B32B 17/06

(54) **RESIN COMPOSITION, AND PREPREG AND USE THEREOF**

(30) Priority: 31.12.2021 CN 202111676353
(71) Applicant: Guangdong Hinno-Tech Co., Ltd., Guangzhou, Guangdong 510555 (CN); Research Institute of Tsinghua, Pearl River Delta, Guangzhou, Guangdong 510530 (CN)
(72) Inventor: GUO, Yongjun, Guangzhou, Guangdong 510555 (CN); XIAO, Hao, Guangzhou, Guangdong 510555 (CN); QI, Xiaolong, Guangzhou, Guangdong 510555 (CN)
(74) Representative: Murgitroyd & Company
(86) International application number: PCT/CN2022/143316
(87) International publication number: WO 2023/125784

(57) **Abstract**

The present application relates to a resin composition, a prepreg, and use thereof. The resin composition includes following components: 50 to 150 parts by weight of a modified epoxy resin; 40 to 120 parts by weight of a modified benzoxazine resin; 20 to 100 parts by weight of a bismaleimide resin; 0.1 to 15 parts by weight of an initiator; and 150 to 550 parts by weight of an inorganic filler, wherein the modified epoxy resin is represented by structural formula (1-1): 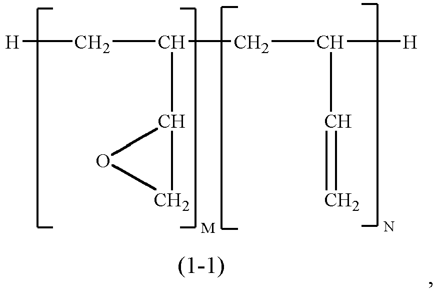 the modified benzoxazine resin is a base benzoxazine resin with a terminal group modified with a double bond structure.

## Description

### TECHNICAL FIELD

The present application relates to the field of polymer materials, particularly to a resin composition, a prepreg, and use thereof.

### BACKGROUND

The continuous development of miniaturization and multi-functionality, and increasing operation speeds of electronic products require improvement in integration of chips and advancement in chip packaging technology. This imposes higher requirements on the performance of substrate materials carrying semiconductor components, particularly on various properties such as dielectric properties of the substrate materials.

Traditional resin materials used in substrates incorporate cyanate esters to reduce dielectric performance, which however often results in decreased resistance to moisture and heat as well as increased linear thermal expansion coefficients. Due to the significant difference in thermal expansion coefficients between semiconductor components and substrates, the substrates can easily bow and warp at elevated temperature conditions due to the discrepancy in thermal expansion coefficients, leading to serious issues such as loose bonding between the semiconductor components and the substrates, as well as between the substrates and the printed circuit boards.

### SUMMARY

In view of this, a main objective of the present application is to provide a resin composition with a low dielectric constant, a low dielectric loss, and a low linear thermal expansion coefficient, as well as a prepreg and use thereof.

The present application provides a resin composition including following components:

| | |
|---|---|
| a modified epoxy resin | 50 to 150 parts by weight; |
| a modified benzoxazine resin | 40 to 120 parts by weight; |
| a bismaleimide resin | 20 to 100 parts by weight; |
| an initiator | 0.1 to 15 parts by weight; and |
| an inorganic filler | 150 to 550 parts by weight; |

wherein the modified epoxy resin is represented by structural formula (1-1): 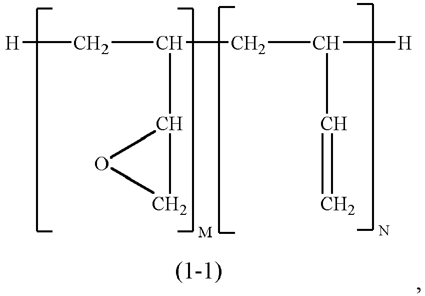
M and N are both positive integers and M+N is ranged from 15 to 50, and the number average molecular weight of the modified epoxy resin is ranged from 1000 to 10000;
the modified benzoxazine resin is a base benzoxazine resin with a terminal group modified with a double bond structure.

In an embodiment, the bismaleimide resin is selected from 4,4'-diphenylmethane bismaleimide, N-2,6-dimethylphenylmaleimide, N-(2,3-dimethylphenyl)maleimide, N-phenylmaleimide, 1,6-bismaleimidohexane, N,N-(4-methyl-1,3-phenylene)bismaleimide, 3,3'-dimethyl-5,5'-diethyl-4,4'-diphenylmethane bismaleimide, bisphenol A diphenyl ether bismaleimide, N'-m-phenylene bismaleimide, diphenylmethane maleimide, biphenyl-type bismaleimide resin, polyphenylmethane maleimide, bis(3-ethyl-5-methyl-4-maleimidophenyl)methane, and combinations thereof.

In an embodiment, the base benzoxazine resin in the modified benzoxazine resin is selected from BPA-type benzoxazine, BPF-type benzoxazine, ODA-type benzoxazine, BPS-type benzoxazine, and combinations thereof.

In an embodiment, in the structure of the modified epoxy resin, M is 3 to 8, N is 5 to 15, and the number average molecular weight of the modified epoxy resin is 1000 to 4000.

In an embodiment, the initiator is selected from di(tert-butylperoxyisopropyl)benzene, dicumyl peroxide, 2,5-dimethyl-2,5-di(tert-butylperoxy)hexane, di-tert-butyl peroxide, 2,5-dimethyl-2,5-di(tert-butylperoxy)-3-hexyne, benzoyl peroxide, chloranil, 2,4,6-tri-tert-butylphenol, tert-butylperoxy isopropyl monocarbonate, azobisisobutyronitrile, and combinations thereof.

In an embodiment, the inorganic filler is selected from silicon dioxide, aluminum oxide, titanium oxide, mica, aluminum hydroxide, magnesium hydroxide, talc, aluminum borate, barium sulfate, calcium carbonate, and combinations thereof.

In an embodiment, the resin composition also includes a halogen-free flame retardant in an amount of 20 to 80 parts by weight.

In an embodiment, the halogen-free flame retardant is selected from the compounds represented by structural formulas (2-1) to (2-4), and combinations thereof:

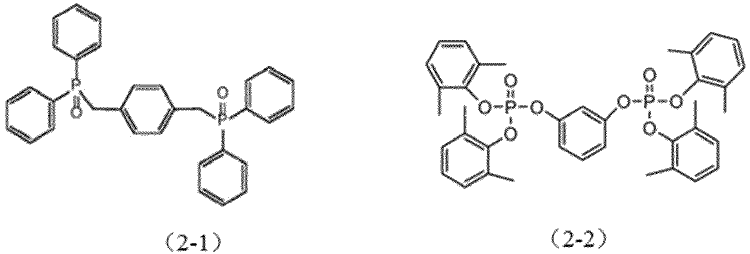

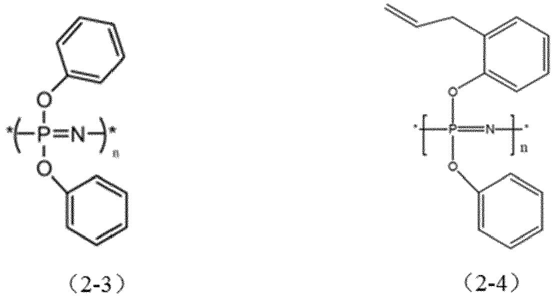

The present application further provides a prepreg including a substrate and a resin material loaded on the substrate, wherein the resin material is the above-described resin composition.

Furthermore, the present application provides use of the prepreg in preparation of a laminate, a copper clad laminate, or a wiring board.

In the above-described resin composition, the polybutadiene-modified epoxy resin and the bismaleimide resin can together form an interpenetrating polymer network. In the presence of the initiator, the polybutadiene-modified epoxy resin reacts with the bismaleimide resin and the polybutadiene-modified epoxy resin reacts with the double bond structure-modified benzoxazine. The interactions occur among the three resins: the bismaleimide resin enhances the heat resistance, rigidity, and strength of the polybutadiene-modified epoxy resin; the polybutadiene-modified epoxy resin improves the dielectric performance of the bismaleimide resin; and the bismaleimide resin and the double bond structure-modified benzoxazine together form a bismaleimide-benzoxazine structure, that addresses the issue of high linear thermal expansion coefficient of the bismaleimide resin. This results in a resin composition with a low dielectric constant, a low dielectric loss, and a low linear thermal expansion coefficient.

### DETAILED DESCRIPTION

The present application can be implemented in many different forms and therefore is not limited to the embodiments described herein. On the contrary, the purpose of providing these embodiments is to make the understanding of the present application more thorough and comprehensive. These embodiments are for illustration rather than limitation of the present application. Furthermore, reference numbers and/or letters may be repeated in different embodiments of the present application. This repetition is for the purpose of simplicity and clarity, and does not itself indicate a relationship between the various embodiments and/or configurations being discussed.

In addition, the terms "first" and "second" are merely used for descriptive purposes, and should not be construed as indicating or implying relative importance or implying the quantity or order of the described technical features. Therefore, the features modified by "first" or "second" may explicitly or implicitly include at least one of the features. In the description of the present application, "a plurality of" means at least two, such as two, three, etc., unless otherwise expressly and specifically defined. In the description of the present application, "some" means at least one, such as one, two, etc., unless otherwise expressly and specifically defined.

The terms "preferably", "more preferably", etc., used in the present application refer to in some circumstances, certain advantageous effects may be provided in certain embodiments of the present application. However, in the same or other circumstances, other embodiments may also be preferable. Furthermore, the description of one or more preferred embodiments does not imply that other embodiments are not available, nor is it intended to exclude other embodiments from the scope of the present application.

When a numerical range is disclosed herein, the range is considered as being continuous and includes the minimum and maximum values of the range, as well as each value between the minimum and maximum values. Further, when the range is for integers, each integer between the minimum and maximum values of the range is included. In addition, when multiple ranges are provided to describe features or characteristics, the ranges can be combined. In other words, unless otherwise specified, all ranges disclosed herein shall be understood to include any and all sub-ranges included therein.

Unless otherwise defined, all technical and scientific terms used herein have the same meaning as commonly understood by those skilled in the art to which the present application belongs. The terms used in the specification of the present application are for the purpose of describing exemplary embodiments only and are not intended to limit the present application. The term "and/or" as used herein refers to any and all combinations of one or more items recited.

The present application provides a resin composition including following components:

| | |
|---|---|
| a modified epoxy resin | 50 to 150 parts by weight; |
| a modified benzoxazine resin | 40 to 120 parts by weight; |
| a bismaleimide resin | 20 to 100 parts by weight; |
| an initiator | 0.1 to 15 parts by weight; and |
| an inorganic filler | 150 to 550 parts by weight; |

wherein the modified epoxy resin is represented by structural formula (1-1): 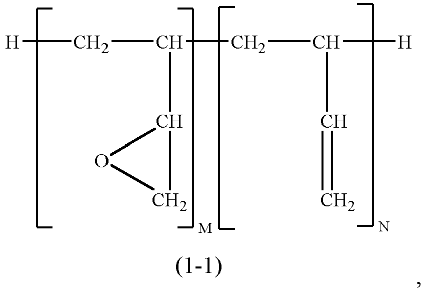 M and N are both positive integers and M+N is ranged from 15 to 50, and the number average molecular weight of the modified epoxy resin is ranged from 1000 to 10000;
the modified benzoxazine resin is a base benzoxazine resin with a terminal group modified with a double bond structure.

In a specific embodiment, in the structure of the modified epoxy resin, M is 3 to 8, N is 5 to 15, and the number average molecular weight of the modified epoxy resin is 1000 to 4000.

It can be understood that values of the number average molecular weight are obtained by conventional molecular weight measurement methods, which can include, but are not limited to, values measured using gel permeation chromatography (GPC).

In a specific embodiment, the bismaleimide resin is selected from 4,4'-diphenylmethane bismaleimide, N-2,6-dimethylphenylmaleimide, N-(2,3-dimethylphenyl)maleimide, N-phenylmaleimide, 1,6-bismaleimidohexane, N,N-(4-methyl-1,3-phenylene)bismaleimide, 3,3'-dimethyl-5,5'-diethyl-4,4'-diphenylmethane bismaleimide, bisphenol A diphenyl ether bismaleimide, N'-m-phenylene bismaleimide, diphenylmethane maleimide, biphenyl-type bismaleimide resin, polyphenylmethane maleimide, bis(3-ethyl-5-methyl-4-maleimidophenyl)methane, and combinations thereof.

Further, the bismaleimide resin can be selected from biphenyl-type bismaleimide resin, polyphenylmethane maleimide, bis(3-ethyl-5-methyl-4-maleimidophenyl)methane, and combinations thereof.

Specifically, the bismaleimide resin can be selected from the bismaleimide resins with trade names of BMI-70, BMI-80, BMI-1000, BMI-1000H, BMI-1100, BMI-1100H, BMI-2000, BMI-2300, BMI-3000, BMI-3000H, BMI-4000H, BMI-5000, BMI-5100, BMI-7000, BMI-7000H, etc., produced by Daiwakasei Industry Co., Ltd.

Preferably, the bismaleimide resin is BMI-2300 with the structural formula of 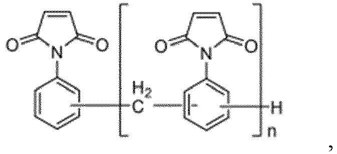 the bismaleimide resin is BMI-5100 with the structural formula of 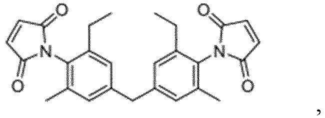 the bismaleimide resin is MIR-3000 produced by Nippon Kayaku Co., Ltd. with the structural formula of

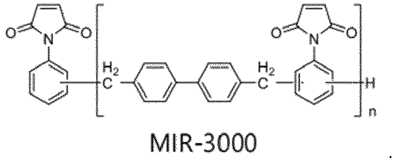

In a specific embodiment, the base benzoxazine resin in the modified benzoxazine resin is selected from BPA-type benzoxazine, BPF-type benzoxazine, ODA-type benzoxazine, BPS-type benzoxazine, and combinations thereof.

Preferably, the modified benzoxazine resin is a BPA-type benzoxazine resin modified with an allyl group, the structural formula of which can be, but is not limited to:

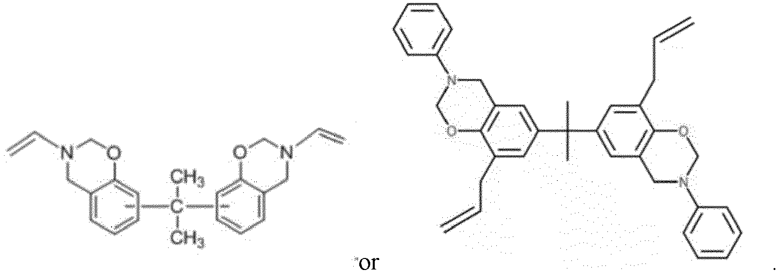

In a specific embodiment, the initiator is selected from di(tert-butylperoxyisopropyl)benzene, dicumyl peroxide, 2,5-dimethyl-2,5-di(tert-butylperoxy)hexane, di-tert-butyl peroxide, 2,5-dimethyl-2,5-di(tert-butylperoxy)-3-hexyne, benzoyl peroxide, chloranil, 2,4,6-tri-tert-butylphenol, tert-butylperoxy isopropyl monocarbonate, azobisisobutyronitrile, and combinations thereof.

In a specific embodiment, the resin composition further includes a halogen-free flame retardant in an amount of 20 to 80 parts by weight.

In a specific embodiment, the halogen-free flame retardant is selected from the compounds represented by structural formulas (2-1) to (2-4), and combinations thereof:

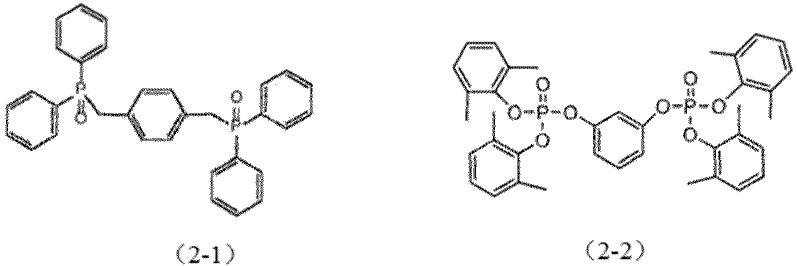

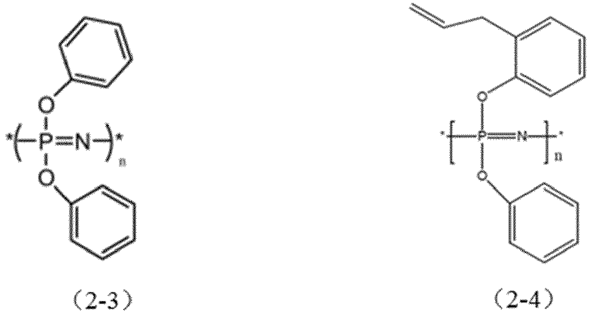

Preferably, the halogen-free flame retardant is the flame retardant of structural formula (2-1).

In a specific embodiment, the inorganic filler is selected from silicon dioxide, aluminum oxide, titanium oxide, mica, aluminum hydroxide, magnesium hydroxide, talc, aluminum borate, barium sulfate, calcium carbonate, and combinations thereof.

It can be understood that the shape of the inorganic filler can be, but is not limited to, spheres, fibers, chips, granules, flakes, or needles.

In the above-described resin composition, the polybutadiene-modified epoxy resin and the bismaleimide resin can together form an interpenetrating polymer network. In the presence of the initiator, the polybutadiene-modified epoxy resin reacts with the bismaleimide resin and the polybutadiene-modified epoxy resin reacts with the double bond structure-modified benzoxazine. The interactions occur among the three resins: the bismaleimide resin enhances the heat resistance, rigidity, and strength of the polybutadiene-modified epoxy resin; the polybutadiene-modified epoxy resin improves the dielectric performance of the bismaleimide resin; and the bismaleimide resin and the double bond structure-modified benzoxazine together form a bismaleimide-benzoxazine structure, that addresses the issue of high linear thermal expansion coefficient of the bismaleimide resin. This results in a resin composition with a low dielectric constant, a low dielectric loss, and a low linear thermal expansion coefficient.

Preferably, the resin composition includes following components:

| | |
|---|---|
| a modified epoxy resin | 80 to 120 parts by weight; |
| a modified benzoxazine resin | 40 to 110 parts by weight; |
| a bismaleimide resin | 30 to 70 parts by weight; |
| an initiator | 0.1 to 5 parts by weight; |
| a flame retardant | 40 to 70 parts by weight; and |
| an inorganic filler | 150 to 450 parts by weight. |

It can be understood that the method for preparing the above-described resin composition includes following steps S10 to S20.

S10, mixing the bismaleimide resin with a solvent to prepare a premixture.

It can be understood that this step is to thoroughly mix the bismaleimide resin with the solvent, which can involve heating at a temperature ranged from 40°C to 80°C.

S20, adding the modified epoxy resin, the modified benzoxazine resin, the halogen-free flame retardant, the inorganic filler, the initiator, and a solvent to the premixture.

Furthermore, the solvent is selected from methanol, ethanol, ethylene glycol monomethyl ether, acetone, butanone, methyl isobutyl ketone, cyclohexanone, toluene, xylene, 2-methoxyethyl acetate, 2-ethoxyethyl acetate, 2-ethoxyethyl acrylate, ethyl acetate, dimethylformamide, dimethylacetamide, propylene glycol methyl ether, and combinations thereof.

Preferably, the solvent is acetone.

The present application further provides a prepreg including a substrate and a resin material loaded on the substrate, wherein the resin material is the above-described resin composition.

The resin composition can be loaded onto the substrate and heated to a semi-cured state to obtain the prepreg. It can be understood that the method for loading the resin composition onto the substrate can include, but is not limited to, impregnation, rolling, molding, coating, rod coating, spraying, or combinations thereof.

The loading step can be repeated multiple times as needed. Additionally, various thermosetting resin compositions with different components and solid contents can be used in the repeated loading to obtain a desired final composition and resin content.

It can be understood that the heating conditions involve heating at a temperature of 80°C to 200°C for 1 minute to 20 minutes to obtain a semi-cured pre-impregnated material, i.e., a prepreg.

Preferably, the heating conditions includes a heating temperature of 110°C to 190°C and a heating time of 2 minutes to 10 minutes.

In a specific embodiment, the substrate is selected from glass fibers, carbon fibers, silicon carbide fibers, asbestos fibers, nylon, polyethylene fibers, aramid fibers, polyimide fibers, polyester fibers, cotton fibers, and combinations thereof.

Preferably, the substrate is glass fiber cloth. The type of the glass fiber cloth can be, but is not limited to, E, NE, D, S, or T type, which can produce a laminate with excellent mechanical strength. More preferably, the glass fiber cloth has undergone flattening treatment. The flattening treatment can be performed by continuously applying appropriate pressure onto the glass fiber cloth with pressure rollers to compress the yarns into flatness.

Furthermore, the present application further provides use of the prepreg in preparation of a laminate, a copper clad laminate, or a wiring board.

The method for preparing the laminate includes a step of laminating at least one above-described prepreg.

Furthermore, the parameters of the laminating process are: hot pressing at a temperature of 170°C to 250°C, a pressure of 10 kgf/cm² to 30 kgf/cm², and a vacuum degree of less than 2 kPa for 60 minutes to 120 minutes.

It should be particularly noted that during the laminating process, one or both sides of multiple prepregs, i.e., a stack, can be covered with a copper foil, and then laminated to obtain a copper clad laminate.

The thickness of the copper foil is ranged from 3µm to 70µm.

It can be understood that the laminate has a low dielectric constant, a low dielectric loss, and a low linear thermal expansion coefficient, and can be widely used in semiconductor packaging.

The following provides specific examples to further elaborate the resin composition and the preparation method thereof of the present application. In the specific examples below, unless otherwise specified, all raw materials are commercially available.

The modified epoxy resins are: JP-100, butadiene-modified epoxy resin, Mn=1300, manufactured by Nippon Soda Co., Ltd.; JP-200, butadiene-modified epoxy resin, Mn=2200, manufactured by Nippon Soda Co., Ltd.; PB4700, butadiene-modified epoxy resin, Mn=3100, manufactured by Daicel Corporation; 901, BPA-type epoxy resin, Mn=1100, manufactured by Hongchang Electronics Co., Ltd.

The modified benzoxazine resins are: 5031, allyl-type benzoxazine, manufactured by Kolon Industries Inc.; CB6900, double bond-modified benzoxazine, manufactured by Coryes Polymer; CB3170, BPA-type benzoxazine, manufactured by Coryes Polymer.

The bismaleimide resins are: BMI-2300, polyphenylmethane maleimide, manufactured by Daiwa Kasei (Japan); BMI-5100, bis(3-ethyl-5-methyl-4-maleimidophenyl)methane, manufactured by Daiwa Kasei (Japan); MIR-3000, biphenyl-type bismaleimide, manufactured by Nippon Kayaku.

The halogen-free flame retardants are: GU304, bis-DPO-type phosphorus-containing flame retardant, manufactured by Coryes Polymer, the melting point is 320°C, the phosphorus content (P%) = 12%, the molecular formula is 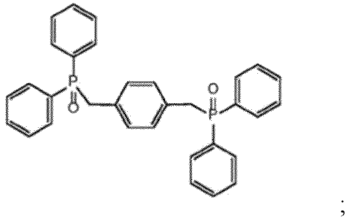 PX-200, resorcinol bis(2.6-dixylenyl phosphate), P%=9%, manufactured by Daihachi Chemical Industry Co., Ltd.; SPB-100, phosphazene compound, P%=13%, manufactured by Otsuka Chemical Co., Ltd.; SPV-100, allyl-modified phosphazene compound, P%=11%, manufactured by Otsuka Chemical Co., Ltd.

The inorganic filler is SC2300-SVJ, double-bond treated spherical silicon dioxide, manufactured by Admatechs Co., Ltd.

The initiator is PERBUTYL P, 1,3-bis(t-butylperoxyisopropyl)benzene, manufactured by NOF Corporation.

The formulations of the resin compositions in the examples and comparative examples are as follows:

| Component | Model | | Example 1 | Example 2 | Example 3 | Example 4 |
|---|---|---|---|---|---|---|
| Modified epoxy resin | butadiene-modified epoxy resin, Mn=1300 | JP-100 | | 100 | | |
| | butadiene-modified epoxy resin, Mn=2200 | JP-200 | 100 | | | 100 |
| | butadiene-modified epoxy resin, Mn=3100 | PB4700 | | | 100 | |
| Modified benzoxazine resin | allyl-type benzoxazine | 5031 | | | | 50 |
| | double bond-modified benzoxazine | CB6900 | 100 | 50 | 50 | |
| Bismaleimide resin | polyphenylmethane maleimide | BMI-2300 | 50 | 50 | 50 | 50 |
| | bis(3-ethyl-5-methyl-4-maleimidophenyl)meth ane | BMI-5100 | | | | |
| | biphenyl-type bismaleimide resin | MIR-3000 | | | | |
| Halogen-free flame retardant | bis-DPO-type phosphorus-containing flame retardant | GU304 | 60 | 50 | 50 | 50 |
| | resorcinol bis (2.6-dixylenyl phosphate) | PX-200 | | | | |
| | phosphazene compound | SPB-100 | | | | |
| | allyl-modified phosphazene compound | SPV-100 | | | | |
| Inorganic filler | double-bond treated spherical silicon dioxide | SC2300-SVJ | 400 | 400 | 400 | 400 |
| Initiator | 1,3-bis(t-butylperoxyiso propyl)benzene | PERBUTYL P | 0.5 | 0.5 | 0.5 | 0.5 |

| Composition | Model | | Example 5 | Example 6 | Example 7 | Example 8 |
|---|---|---|---|---|---|---|
| Modified epoxy resin | butadiene-modified epoxy resin, Mn=1300 | JP-100 | | | | |
| | butadiene-modified epoxy resin, Mn=2200 | JP-200 | 100 | 100 | 100 | 100 |
| | butadiene-modified epoxy resin, Mn=3100 | PB4700 | | | | |
| Modified benzoxazine resin | allyl-type benzoxazine | 5031 | | | | |
| | double bond-modified benzoxazine | CB6900 | 50 | 50 | 50 | 50 |
| Bismaleimide resin | polyphenylmethane maleimide | BMI-2300 | 50 | 50 | | |
| | bis(3-ethyl-5-methyl-4-maleimidophenyl)meth ane | BMI-5100 | | | 50 | |
| | biphenyl-type bismaleimide resin | MIR-3000 | | | | 50 |
| Halogen-free flame retardant | bis-DPO-type phosphorus-containing flame retardant | GU304 | 50 | 50 | 50 | 50 |
| | resorcinol bis (2.6-dixylenyl phosphate) | PX-200 | | | | |
| | phosphazene compound | SPB-100 | | | | |
| | allyl-modified phosphazene compound | SPV-100 | | | | |
| Inorganic filler | double-bond treated spherical silicon dioxide | SC2300-SVJ | 200 | 400 | 400 | 400 |
| Initiator | 1,3-bis(t-butylperoxyiso propyl)benzene | PERBUTYL P | 0.5 | 0.5 | 0.5 | 0.5 |

| Component | Model | | Comparative Example | | | |
|---|---|---|---|---|---|---|
| | | | 1 | 2 | 3 | 4 |
| Modified epoxy resin | butadiene-modified epoxy resin, Mn=1300 | JP-100 | | | | |
| | butadiene-modified epoxy resin, Mn=2200 | JP-200 | 100 | 100 | 100 | 100 |
| | butadiene-modified epoxy resin, Mn=3100 | PB4700 | | | | |
| | BPA-type epoxy resin | 901 | | | | |
| Modified benzoxazine resin | allyl-type benzoxazine | 5031 | | | | |
| | double bond-modified benzoxazine | CB6900 | 50 | 50 | 50 | 50 |
| | BPA-type benzoxazine | CB3170 | | | | |
| Bismaleimide resin | polyphenylmethane maleimide | BMI-2300 | 50 | 50 | 50 | 50 |
| | bis(3-ethyl-5-methyl-4-maleimidophenyl)meth ane | BMI-5100 | | | | |
| | biphenyl-type bismaleimide resin | MIR-3000 | | | | |
| Halogen-free flame retardant | bis-DPO-type phosphorus-containing flame retardant | GU304 | | | | 20 |
| | resorcinol bis (2.6-dixylenyl phosphate) | PX-200 | 66 | | | |
| | phosphazene compound | SPB-100 | | 46 | | |
| | allyl-modified phosphazene compound | SPV-100 | | | 54 | |
| Inorganic filler | double-bond treated spherical silicon dioxide | SC2300-SVJ | 400 | 400 | 400 | 400 |
| Initiator | 1,3-bis(t-butylperoxyiso propyl)benzene | PERBUTYL P | 0.5 | 0.5 | 0.5 | 0.5 |

| Component | Model | | Comparative Example | | | | |
|---|---|---|---|---|---|---|---|
| | | | 5 | 6 | 7 | 8 | 9 |
| Modified epoxy resin | butadiene-modified epoxy resin, Mn=1300 | JP-100 | | | | | |
| | butadiene-modified epoxy resin, Mn=2200 | JP-200 | 100 | 100 | 100 | | 100 |
| | butadiene-modified epoxy resin, Mn=3100 | PB4700 | | | | | |
| | BPA-type epoxy resin | 901 | | | | 100 | |
| Modified benzoxazine resin | allyl-type benzoxazine | 5031 | | | | | |
| | double bond-modified benzoxazine | CB6900 | | | | 50 | |
| | BPA-type benzoxazine | CB3170 | | | | | 50 |
| Bismaleimide resin | polyphenylmethane maleimide | BMI-2300 | 100 | | | 50 | 50 |
| | bis(3-ethyl-5-methyl-4-maleimidophenyl)meth ane | BMI-5100 | | 100 | | | |
| | biphenyl-type bismaleimide resin | MIR-3000 | | | 100 | | |
| Halogen-free flame retardant | bis-DPO-type phosphorus-containing flame retardant | GU304 | 50 | 50 | 50 | 50 | 50 |
| | resorcinol bis (2.6-dixylenyl phosphate) | PX-200 | | | | | |
| | phosphazene compound | SPB-100 | | | | | |
| | allyl-modified phosphazene compound | SPV-100 | | | | | |
| Inorganic filler | double-bond treated spherical silicon dioxide | SC2300-SVJ | 400 | 400 | 400 | 400 | 400 |
| Initiator | 1,3-bis(t-butylperoxyiso propyl)benzene | PERBUTYL P | 0.5 | 0.5 | 0.5 | 0.5 | 0.5 |

The preparation method of the resin compositions in the examples and comparative examples is as follows:

Firstly, the bismaleimide resin was mixed with acetone as a solvent. The premixture was heated to 60°C and stirred thoroughly to dissolve the bismaleimide resin completely in acetone, yielding an acetone solution with a solid content of 40% by mass. Then, the modified epoxy resin and the modified benzoxazine resin were added according to the proportions, and stirred for 2 hours to ensure complete dissolution. Finally, the halogen-free flame retardant, the inorganic filler, the initiator, and an appropriate amount of acetone were added, and the mixture was thoroughly dispersed by ball milling to obtain the resin composition.

The preparation method of the prepregs loaded with the resin compositions in the examples and comparative examples was as follows:

The glass fiber cloths, which were the 2116 cloths produced by Grace Fabric Technology Co., Ltd., were separately impregnated with the resin compositions prepared in the examples or comparative examples, and heated at 160°C for about 3 minutes for drying, thereby obtaining the prepregs. The solid content of the resin compositions can be adjusted to obtain the prepregs with a solid content of 50% by mass.

The preparation method of the copper clad laminate was as follows:

Eight prepregs corresponding to each example or comparative example were stacked with 35µm copper foil placed on both sides. The stack was then heated and pressed at a temperature of 220°C and a pressure of 25 kgf/cm² for 2 hours, thereby obtaining a copper clad laminate with a thickness of about 0.9mm.

### Performance Testing:

1. Peeling strength was determined according to IPC-TM-650 2.4.8 by using a universal tensile machine.
2. Glass-transition temperature (Tg): Tg was measured using a dynamic mechanical analyzer (DMA) (DMA850 manufactured by TA Instruments) at a heating rate of 3°C/min according to the standard methods IPC-TM-650 2.4.25C and 24C published by the Institute for Interconnecting and Packaging Electronic Circuits (IPC).
3. Measurement of dielectric constant and dielectric loss: Dielectric constant (Dk) and dissipation factor (Df) were measured using a network analyzer (Agilent, model E5071C) at a working frequency of 10 gigahertz (GHz) following the IPC-TM-650 2.5.5.13 standard.
4. 288°C solder tin resistance test: The test sample, which had undergone pressure cooker testing (PCT) for 2 hours, was immersed into 288°C solder tin for 6 minutes, and whether the test sample delaminated was recorded.
5. Thermal expansion coefficient testing and expansion rate in X/Y/Z axes: The coefficient of thermal expansion and expansion rate in X/Y/Z axes of the test sample were measured using a thermal expansion analyzer (TA Instruments, model TA Q800), the testing temperature is 50°C to 260°C, and the heating rate is 10°C/min.
6. Flame retardant testing: the self-extinguishing time of the test sample after combustion was tested using a Bunsen burner, methane gas, and a stopwatch, according to the UL-94 standard, and the test sample was rated based on the self-extinguishing time.
7. Elastic modulus: The elastic modulus was tested using a universal tensile machine according to the GB/T 22315-2008 standard.

The performances of the copper clad laminates in the examples and comparative examples are as follows:

| Characteristics of copper clad laminate | | Example | | | | | | | |
|---|---|---|---|---|---|---|---|---|---|
| | | 1 | 2 | 3 | 4 | 5 | 6 | 7 | 8 |
| Peeling strength (1b/in) | 1oz copper foil | 8.0 | 7.0 | 8.5 | 8.0 | 7.8 | 7.5 | 7.5 | 8.5 |
| Elastic modulus (GPa) | | 30 | 29 | 30 | 29 | 25 | 30 | 29 | 30 |
| DMA (°C) | 3°C/min | 200 | 220 | 240 | 240 | 265 | 265 | 265 | 250 |
| Heat resistance test | 288°C tin immersion | Pass | Pass | Pass | Pass | Pass | Pass | Pass | Pass |
| Thermal expansion coefficient in X/Y axes (ppm/°C) | Before Tg | 8 | 8 | 11 | 11 | 11 | 9.5 | 10.5 | 12 |
| Thermal expansion coefficient in Z axis (ppm/°C) | After Tg | 160 | 160 | 200 | 200 | 200 | 150 | 150 | 160 |
| CTE in Z axis | 50°C-260°C | 1.8% | 2.0% | 1.8% | 2.1% | 2.0% | 1.5% | 1.5% | 1.6% |
| Flame retardant level | 94UL | V0 | V0 | V0 | V0 | V0 | V0 | V0 | V0 |
| Dk | 10GHz | 4.10 | 4.10 | 4.15 | 4.20 | 3.95 | 4.05 | 4.05 | 4.00 |
| Df | | 0.0070 | 0.0070 | 0.0080 | 0.0100 | 0.0070 | 0.0070 | 0.0070 | 0.0065 |

| Characteristics of copper clad laminate | | Comparative Example | | | | | | | | |
|---|---|---|---|---|---|---|---|---|---|---|
| | | 1 | 2 | 3 | 4 | 5 | 6 | 7 | 8 | 9 |
| Peeling strength (1b/in) | 1oz copper foil | 7.5 | 7.5 | 8.0 | 7.6 | 6.0 | 6.0 | 9.0 | 10.0 | 8.0 |
| Elastic modulus (GPa) | | 28 | 28 | 29 | 30 | 29 | 28 | 30 | 31 | 29 |
| DMA (°C) | 3°C/min | 180 | 200 | 220 | 265 | 300 | 300 | 260 | 180 | 225 |
| Heat resistance test | 288°C tin immersion | Pass | Pass | Pass | Pass | Pass | Pass | Pass | Pass | Pass |
| Thermal expansion coefficient in X/Y axes (ppm/°C) | Before Tg | 9.5 | 9.5 | 9.5 | 9.5 | 12 | 13 | 14 | 14.5 | 11.5 |
| Thermal expansion coefficient in Z axis (ppm/°C) | After Tg | 220 | 220 | 210 | 150 | 150 | 150 | 160 | 180 | 180 |
| CTE in Z axis | 50°C-260°C | 2.8% | 2.3% | 2.1% | 1.5% | 1.2% | 1.2% | 1.6% | 2.9% | 2.2% |
| Flame retardant level | 94UL | V0 | V0 | V0 | V1 | V0 | V0 | V0 | V-0 | V-0 |
| Dk | 10GHz | 4.05 | 4.05 | 4.05 | 4.05 | 4.10 | 4.10 | 4.00 | 4.15 | 4.10 |
| Df | | 0.0065 | 0.0095 | 0.0075 | 0.0070 | 0.0075 | 0.0075 | 0.0060 | 0.0110 | 0.0090 |

It can be seen from the performances of the copper clad laminates in the examples and comparative examples that a halogen-free cured product with a high glass transition temperature, a high flexural modulus, an excellent dielectric performance, and a low XY linear thermal expansion coefficient can be obtained using the resin composition in Example 6. This resin composition contains polybutadiene-modified epoxy resin, double bond-modified benzoxazine resin, bismaleimide resin, and bis-DPO-type phosphorus-containing flame retardant.

In Comparative Examples 1, 2, and 3, the phosphorus-containing flame retardants in the resin compositions can react with the resins, resulting in a decreased Tg and deterioration of the electrical performance of the cured product. In Comparative Example 4, the proportion of the bis-DPO-type phosphorus-containing flame retardant in the resin composition is insufficient, leading to the flame retardant level of the cured product only meeting 94UL-V1. In Example 5, the proportion of the filler in the resin composition is insufficient, resulting in a lower elastic modulus of the cured product. In the bismaleimide resins in the resin compositions of Examples 6, 7, and 8, BMI-2300 has the smallest XY linear thermal expansion coefficient. The copper-clad laminate prepared using the resin composition of Example 6 can achieve a Tg of 265°C, a peeling strength of 7.5 lb/in, a Df of 0.0070 at 10 GHz, an elastic modulus of 30 GPa, and an XY linear thermal expansion coefficient of 9.5 ppm/°C.

The technical features of the above-mentioned embodiments can be combined arbitrarily. In order to make the description concise, not all possible combinations of the technical features are described in the embodiments. However, as long as there is no contradiction in the combination of these technical features, the combinations should be considered as in the scope of the present application.

The above-described embodiments are only several implementations of the present application, and the descriptions are relatively specific and detailed, but they should not be construed as limiting the scope of the present application. It should be understood by those of ordinary skill in the art that various modifications and improvements can be made without departing from the concept of the present application, and all fall within the protection scope of the present application. It should be understood that the technical solutions obtained by those of ordinary skill in the art through logical analysis, reasoning, or limited experimentation based on the technical solutions provided in the present application are within the protection scope of the claims appended to the present application. Therefore, the patent protection of the present application shall be defined by the appended claims, and the specification can be used to interpret the contents of the claims.

## Claims

1. A resin composition comprising following components:
| | |
|---|---|
| a modified epoxy resin | 50 to 150 parts by weight; |
| a modified benzoxazine resin | 40 to 120 parts by weight; |
| a bismaleimide resin | 20 to 100 parts by weight; |
| an initiator | 0.1 to 15 parts by weight; and |
| an inorganic filler | 150 to 550 parts by weight; |
wherein the modified epoxy resin is represented by structural formula (1-1): 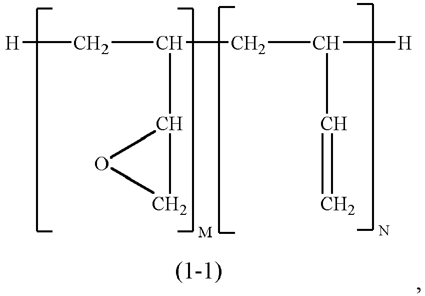
M and N are both positive integers and M+N is ranged from 15 to 50, and a number average molecular weight of the modified epoxy resin is ranged from 1000 to 10000; and
the modified benzoxazine resin is a base benzoxazine resin with a terminal group modified with a double bond structure.

2. The resin composition according to claim 1, wherein the bismaleimide resin is selected from the group consisting of 4,4'-diphenylmethane bismaleimide, N-2,6-dimethylphenylmaleimide, N-(2,3-dimethylphenyl)maleimide, N-phenylmaleimide, 1,6-bismaleimidohexane, N,N-(4-methyl-1,3-phenylene)bismaleimide, 3,3'-dimethyl-5,5'-diethyl-4,4'-diphenylmethane bismaleimide, bisphenol A diphenyl ether bismaleimide, N'-m-phenylene bismaleimide, diphenylmethane maleimide, biphenyl-type bismaleimide resin, polyphenylmethane maleimide, bis(3-ethyl-5-methyl-4-maleimidophenyl)methane, and combinations thereof.

3. The resin composition according to claim 1, wherein the base benzoxazine resin in the modified benzoxazine resin is selected from the group consisting of BPA-type benzoxazine, BPF-type benzoxazine, ODA-type benzoxazine, BPS-type benzoxazine, and combinations thereof.

4. The resin composition according to claim 1, wherein in the structure of the modified epoxy resin, M is 3 to 8, N is 5 to 15, and the number average molecular weight of the modified epoxy resin is 1000 to 4000.

5. The resin composition according to claim 1, wherein the initiator is selected from the group consisting of di(tert-butylperoxyisopropyl)benzene, dicumyl peroxide, 2,5-dimethyl-2,5-di(tert-butylperoxy)hexane, di-tert-butyl peroxide, 2,5-dimethyl-2,5-di(tert-butylperoxy)-3-hexyne, benzoyl peroxide, chloranil, 2,4,6-tri-tert-butylphenol, tert-butylperoxy isopropyl monocarbonate, azobisisobutyronitrile, and combinations thereof.

6. The resin composition according to claim 1, wherein the inorganic filler is selected from the group consisting of silicon dioxide, aluminum oxide, titanium oxide, mica, aluminum hydroxide, magnesium hydroxide, talc, aluminum borate, barium sulfate, calcium carbonate, and combinations thereof.

7. The resin composition according to any one of claims 1 to 6, further comprising a halogen-free flame retardant in an amount of 20 to 80 parts by weight.

8. The resin composition according to claim 7, wherein the halogen-free flame retardant is selected from the group consisting of compounds represented by structural formulas (2-1) to (2-4), and combinations thereof:

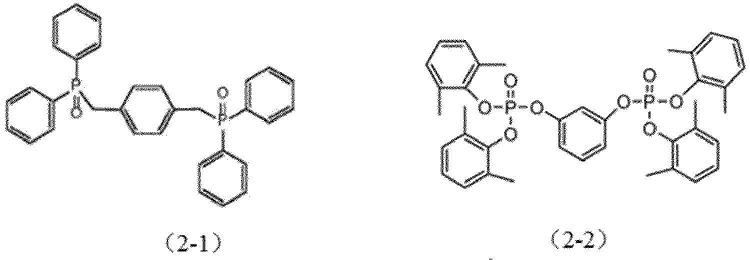

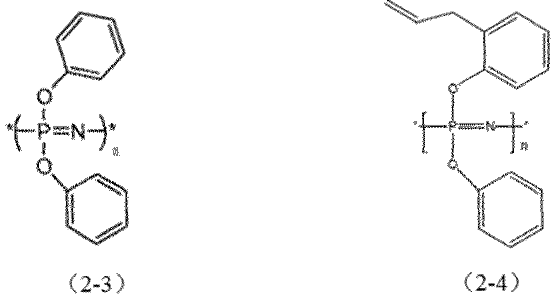

9. A prepreg comprising a substrate and a resin material loaded on the substrate, wherein the resin material is the resin composition according to any one of claims 1 to 8.

10. Use of the prepreg according to claim 9, in preparation of a laminate, a copper clad laminate, or a wiring board.
